# EUROPEAN PATENT SPECIFICATION

(11) **EP 2 434 553 B1**
(45) Date of publication and mention of the grant of the patent: **26.12.2018**
(21) Application number: 11179778.3
(22) Date of filing: 01.09.2011
(51) Int. Cl.: H01L 33/48, H01L 33/56, H01L 33/44, H01L 33/54, H01L 33/60

(54) **Light emitting device package**
Verpackung für lichtemittierende Vorrichtung
Packaging de dispositif d'émission lumineuse

(30) Priority: 24.09.2010 KR 20100092844; 24.09.2010 KR 20100092845
(43) Date of publication of application: 28.03.2012
(73) Proprietor: LG Innotek Co., Ltd., Seoul, 04637 (KR)
(72) Inventor: Park, Jun Seok, 100-714 Seoul (KR); Kim, Muyng Gi, 100-714 Seoul (KR); Bak, Gyu Hyeong, 100-714 Seoul (KR)
(74) Representative: Zardi, Marco

(56) References cited:
- KR-A- 20100 077 498
- US-A1- 2007 228 932
- US-A1- 2007 262 336
- US-A1- 2007 269 915
- US-A1- 2008 111 148
- US-A1- 2009 010 017

## Description

This application claims the benefit of Korean Patent Application No. 10-2010-0092844, and Korean Patent Application No. 10-2010-0092845 filed on September 24, 2010.

### BACKGROUND OF THE INVENTION

### Field of the Invention

The present invention relates to a light emitting device package for prevention of thermal degradation or for moisture-proofing and a lighting apparatus using the same.

### Discussion of the Related Art

Generally, light emitting diodes constitute a light emitting source using compound semiconductor materials, such as GaAs, AlGaAs, GaN, InGaN, and AlGaInP, and are capable of realizing various colors.

Criteria used when evaluating light emitting diodes include color, brightness, luminosity and the like. Although the light emitting diodes may be primarily evaluated by compound semiconductor materials contained in the light emitting diodes, the configuration of a chip mounting package may be a secondary criteria used to evaluate the light emitting diodes. Nowadays, the configuration of such a package has attracted attention.

In particular, light emitting diodes are increasingly reduced in size according to the tendency of information and communication appliances to become increasingly smaller and slimmer, and take the form of a Surface Mount Device (SMD) directly mounted on a Printed Circuit Board (PCB).

Accordingly, SMD type light emitting diode lamps for display devices have been developed. These SMD type light emitting diode lamps have been used in a variety of display devices, such as multi-color displays, text displays, and image displays, as a substitute for conventional lamps.

As the range of fields in which light emitting diodes are employed continues to increase, light emitting diodes for use in daily lamps and rescue lamps require a greater brightness and thus, high-output light emitting diodes have entered into widespread use. KR20100077498A discloses a light source package including a metal pattern layer reflecting light is formed on the upper side of a substrate, and a pattern protection layer is formed on the metal pattern layer, wherein the pattern protection layer is made of a transparent conductive material. US 2007/269915 A1 discloses a New Moisture-Resistant LED Device with Ceramic Substrate. US 2009/010017A1 discloses a light emitting device comprising a metal reflecting member, a light emitting element fixed to the metal reflecting member, a glass film that covers the metal reflecting member and has Si-N bonds, and a translucent resin that covers the glass film. US2007/228932A1 discloses light-emitting device including a frame, an LED chip provided on the frame, and a fluorescent layer containing an inorganic fluorescent material and an organic fluorescent material and being provided on the LED chip, US 2008/11148A1 discloses a LED package including a high thermal conductivity substrate, a high reflectivity for visible light and/or UV light, and good aging properties. US2007/262336 A1 discloses a LED package having a reflective film between the encapsulant and the package body.

### SUMMARY OF THE INVENTION

Accordingly, the present invention is directed to a light emitting device package using the same that substantially obviate one or more problems due to limitations and disadvantages of the related art.

The present invention is to provide a light emitting device package, which is free from thermal degradation by preventing reactions between moisture and light or between moisture and heat, and a lighting apparatus using the same.

Another object of the present invention is to provide a light emitting device array module in which a protective layer capable of preventing invasion of corrosive agents including moisture is coated on an outer surface of a board on which light emitting devices are arranged, thereby providing the light emitting device array module with enhanced reliability and extended lifespan, and a method for forming the protective layer of the light emitting device array module.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, a light emitting diode package includes a light emitting device, a package body supporting the light emitting device, at least one electrode provided on the package body and electrically connected to the light emitting device, a encapsulant covering the light emitting device, and a protective layer placed between the filler and the package body, wherein the protective layer contains at least one selected from the group consisting of moisture blocking material and ultraviolet blocking material, wherein at least a partial surface of the protective layer contacting the encapsulant includes a toothed pattern, characterized in that the toothed pattern has an inverted trapezoidal shape.

In accordance with another aspect, a light emitting device array module includes a supporting substrate, at least one light emitting device arranged on the supporting substrate, and a protective layer placed on the at least one light emitting device and the supporting plate, wherein the protective layer contains a moisture-proof material having a moisture transmission rate of 100 g/m₂ every 24 hours.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, and together with the description serve to explain the principle of the invention. In the drawings:
FIG. 1 is a view explaining a basic concept of a light emitting device package according to an embodiment not part of the invention;
FIG. 2A is a view illustrating a horizontal type light source;
FIG. 2B is a view illustrating a vertical type light source;
FIG. 2C is a view illustrating a hybrid type light source;
FIGs. 3A and 3B are views explaining functions of a protective layer;
FIGs. 4 to 9 are views illustrating various positions of the protective layer according to different embodiments not part of the invention;
FIGs. 10 and 11 are views illustrating a protective multi-layer;
FIG. 12 is a view illustrating a protective layer made of a mixture;
FIGs. 13 and 14 are views illustrating a protective layer having a toothed pattern;
FIG. 15 is a sectional view of the toothed pattern;
FIG. 16 is a view illustrating a protective layer formed on a package body having a toothed pattern;
FIG. 17 is a view illustrating a protective layer having a gradually varying thickness;
FIGs. 18 and 19 are views illustrating a package body having a pattern of a plurality of fine recesses and a protective layer;
FIG. 20 is a view illustrating a basic concept of a light emitting device array module according to one embodiment not part of the invention;
FIG. 21 is a view illustrating a light emitting device array module according to another embodiment not part of the invention;
FIG. 22 is a view illustrating a light emitting device array module according to a further embodiment not part of the invention;
FIG. 23 is a graph comparing performances of initial high-speed operations per unit time based on the presence and absence of a protective layer;
FIG. 24 is a flow chart illustrating a method for forming a protective layer of a light emitting device array module according to an embodiment not part of the invention; and
FIG. 25 is a view illustrating an embodiment not part of the invention of a lighting apparatus having a light emitting device package or a light emitting device array module.

### DETAILED DESCRIPTION OF THE INVENTION

Reference will now be made in detail to embodiments related to the present invention, examples of which are illustrated in the accompanying drawings. Wherever possible, the same reference numbers will be used throughout the drawings to refer to the same or like parts.

In the following description of the embodiments, it will be understood that, when an element such as a layer (film), region, pattern, or structure is referred to as being "on" or "under" another element, it can be "directly" on or under another element or can be "indirectly " formed such that an intervening element may also be present. Also, it will also be understood that criteria of on or under is on the basis of the drawing.

In the drawings, dimensions of layers are exaggerated, omitted or schematically illustrated for clarity and description convenience. In addition, dimensions of constituent elements do not entirely reflect actual dimensions.

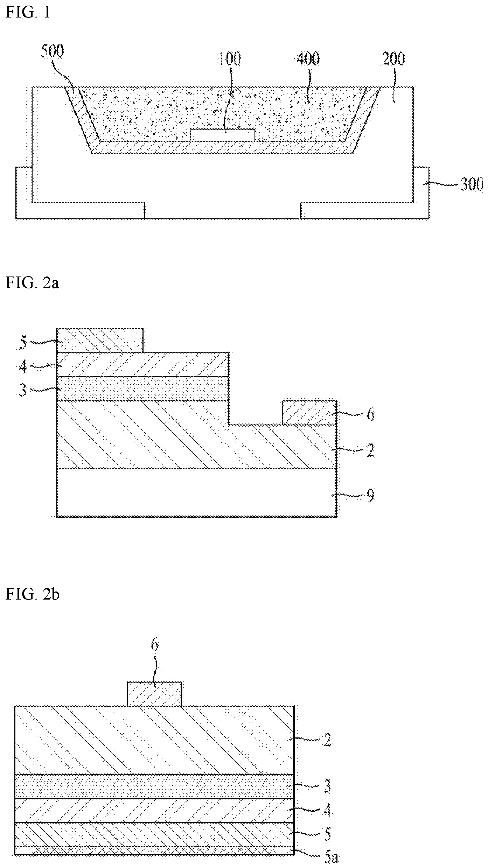

FIG. 1 is a view explaining a concept of a light emitting device package according to an embodiment not part of the invention.

As illustrated in FIG. 1, a light emitting device package may include a light emitting device 100, a package body 200, an electrode 300, a filler 400, and a protective layer 500.

Here, the light emitting device 100 includes a Light Emitting Diode (LED) chip. The LED chip includes a blue LED chip or an ultraviolet LED chip, or a package combining at least one or more of a red LED chip, a green LED chip, a blue LED chip, a yellow-green LED chip, and a white LED chip.

A white LED may be realized by coupling a yellow phosphor to a blue LED, or by coupling both a red phosphor and a green phosphor to a blue LED.

The light emitting device 100 may be classified into a horizontal type, a vertical type, and a hybrid type based on a configuration thereof.

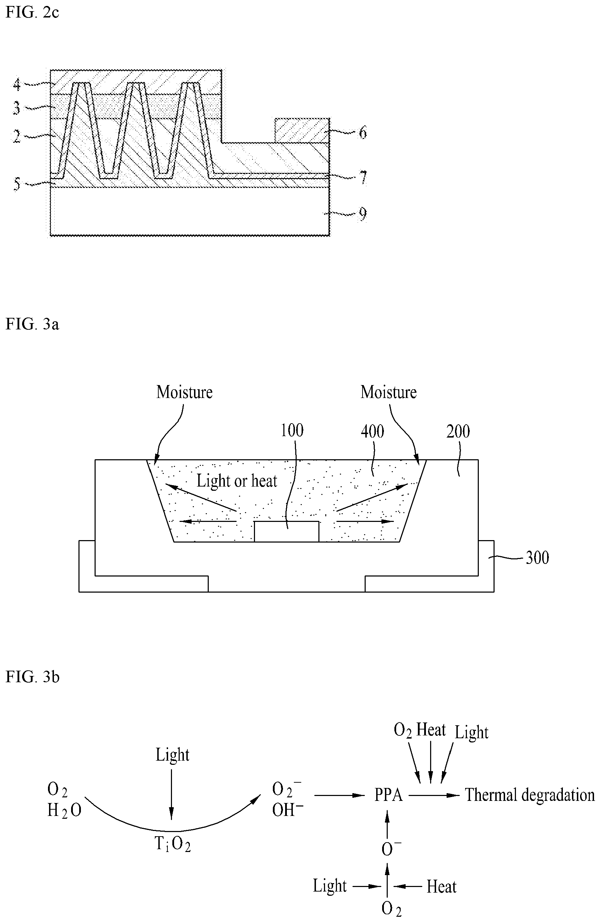

FIG. 2A is a view illustrating a horizontal type light source, FIG. 2B is a view illustrating a vertical type light source, and FIG. 2C is a view illustrating a hybrid type light source.

Referring to FIG. 2A, the horizontal type light source 100 includes a silicon or sapphire substrate 9 that defines a lowermost layer.

An n-type semiconductor layer 2 may be located on the substrate 9. The n-type semiconductor layer 2 may be made of n-GaN, for example.

An active layer 3 may be located on the n-type semiconductor layer 2. The active layer 3 may be made of InGaN (well layer) and GaN (barrier layer), for example.

A p-type semiconductor layer 4 may be located on the active layer 3. The p-type semiconductor layer 4 may be made of p-GaN, for example.

A p-type electrode 5 may be located on the p-type semiconductor layer 4. The p-type electrode 5 may contain at least one of chrome (Cr), nickel (Ni), or gold (Au), for example.

An n-type electrode 6 may be located on the n-type semiconductor layer 2. The n-type electrode 6 may contain at least one of Cr, Ni, or Au, for example.

Referring to FIG. 2B, the vertical type light source 100 may include the p-type electrode 5 having a reflecting surface 5a, the p-type semiconductor layer 4, the active layer 3, the n-type semiconductor layer 2, and the n-type electrode 6, which are sequentially stacked one above another.

Considering the operating principle of the above-described light source 100, when voltage is applied to the p-type electrode 5 and the n-type electrode 6, hole-electron pairs are formed in the active layer 3, enabling emission of light corresponding to a band gap (energy gap) between a conduction band and a valence band.

Referring to FIG. 2C, the hybrid type light source 100 includes the n-type semiconductor layer 2, the active layer 3, and the p-type semiconductor layer 4, which are sequentially stacked on the substrate 9.

The n-type electrode 6 is formed on the n-type semiconductor layer 2, and the p-type electrode 5 is formed between the substrate 9 and the n-type semiconductor layer 2 so as to be brought into contact with the p-type semiconductor layer 4 through the n-type semiconductor layer 2 and the active layer 3.

Specifically, the p-type electrode 5 is brought into contact with the p-type semiconductor layer 4 through a hole penetrating the n-type semiconductor layer 2 and the active layer 3.

An insulating film 7 is coated on a side surface of the hole to electrically insulate the p-type electrode 5.

In an embodiment, the light source 100 having the above-described configuration may include any one substrate selected from among an Al₂O₃ substrate, a semiconductor substrate, and a conductive substrate having a light extraction structure, and a buffer layer made of any one material selected from among GaN Strained layer Superlattice (SLS), AlN SLS, AlGaN SLS, and InGaN/GaN SLS may be formed on the substrate. Also, a first n-type semiconductor layer made of any one material selected from among GaN SLS, AlGaN SLS, InGaN SLS, InAlGaN SLS, and AlInN SLS may be formed on the buffer layer.

Here, the first n-type semiconductor layer may be made of a semiconductor material having a composition equation of InxAlyGa1-x-yN (0≤x≤1, 0≤y≤1, 0≤x+y≤1) with an n-type dopant, such as Si, Ge, or Sn.

A second n-type semiconductor layer made of any one material selected from among InGaN/GaN SLS, AlGaN/GaN SLS, InGaN/InGaN SIS, AlGaN/InGaN SLS (about, three to ten layers) may be formed on the first n-type semiconductor layer. An active layer made of a material selected from among InGaN/GaN and InGan/InGaN (well layer)/(barrier layer) may be formed on the second n-type semiconductor layer.

Here, the active layer may take the form of a single quantum well, a multi quantum well, a quantum point, or a quantum line.

Next, a first p-type semiconductor layer made of any one material selected from among AlGaN SLS, AlGaN/GaN SLS (about 30 nm or less), and the like may be formed on the active layer, and a second p-type semiconductor layer made of any one material selected from among GaN SLS, AlGaN/GaN SLS, and the like may be formed on the first p-type semiconductor layer.

Here, a semiconductor material having a composition equation of InxAlyGa1-x-yN (0≤x≤1, 0≤y≤1, 0≤x+y≤1) may be used with a p-type dopant, such as Mg, Zn, Ca, Sr, or Ba.

Next, a first electrode (an n-type electrode), a second electrode pad (a p-type electrode pad), a second electrode (an ohmic contact layer or a transparent layer) may be formed into a single layer or multiple layers by use of one or more materials selected from among Indium Tin Oxide (ITO), Indium Zinc Oxide (IZO), Indium Zinc Tin Oxide (IZTO), Indium Aluminum Zinc Oxide (IAZO), Indium Gallium Zinc Oxide (IGZO), Indium Gallium Tin Oxide (IGTO), Aluminum Zinc Oxide (AZO), Antimony Tin Oxide (ATO), Gallium Zinc Oxide (GZO), IrOx, RuOx, RuOx/ITO, Ni, Ag, Ni/IrOx/Au, and Ni/IrOx/Au/ITO.

As described above, the light source 100 of the present embodiment may be selected from among various types of light emitting devices.

In the meantime, the package body 200 includes a recess-shaped injection space for the filler 400 in a central region thereof, and the central region of the package body 200 supports the light emitting device 100.

The package body 200 may be made of a highly heat resistant resin containing liquid crystal polymer, thermoplastics, and crystalline polystyrene. Examples of the highly heat resistant resin include polyphthalamide (PPA) containing TiO₂.

The electrode 300 is provided on the package body 200 and is electrically connected to the light emitting device 100 so as to extend outward from the package body 200.

The filler 400 is injected into the filler injection space of the package body 200 to cover the light emitting device 100.

Here, the filler 400 may include transparent epoxy, silicon based resin, and a mixture resin thereof, and may be formed by a dispensing process.

The protective layer 500 may be formed on a surface of the package body 200 at which at least one of light and heat generated by the light emitting device 100 arrives.

The protective layer 500 may contain moisture blocking material and/or ultraviolet blocking material.

In this case, the moisture blocking material may include at least one of polytetrafluoroethylene (PTFE), fire-retardant polyvinylchloride (PVC), fire-retardant polyester, polyethyleneimide (PEI), silicon, silicon rubber, fluoro resin, Teflon, polyvinylchloride (PVC), polyethylene (PE), poly olefin (PO), CF₄, CH₄, or tetraethyl othrosilicate (TEOS).

The ultraviolet blocking material may include at least one of chrome, aluminum, titanium dioxide, zinc oxide, magnesium silicate, magnesium oxide, or kaolin.

The protective layer is formed for the following reasons.

FIGs. 3A and 3B are views explaining functions of the protective layer. More particularly, FIG. 3A is a view illustrating a moisture permeated region and a light and heat arrival region of the light emitting device, and FIG. 3B is a view schematically illustrating a molecular formula showing thermal degradation reactions caused between exterior moisture and oxygen and interior light and heat.

As illustrated in FIGs. 3A and 3B, if exterior moisture and oxygen permeate an interface between the package body 200 and the filler 400, light and heat generated by the light emitting device 100 induce reactions with the permeated moisture or oxygen.

The reactions may accelerate thermal degradation of the package body 200 and may cause the package body 200 to easily change color, thereby resulting in a change in the color of light to be emitted.

More specifically, if moisture (H₂O) permeated from the outside comes into contact with TiO₂ contained in polyphthalamide (PPA) of the package body 200 and light and heat generated by the light emitting device 100 are applied, O₂ ions and OH ions are produced by reactions between moisture and TiO₂. Reactions between the O₂ ions or O ions derived from O₂ and PPA of the package body 200 may cause thermal degradation of PPA.

In conclusion, light and heat catalyzed reactions between moisture and oxygen and PPA of the package body accelerates thermal degradation of the package body, thereby problematically changing the color of light finally emitted from the light emitting device package.

Accordingly, preventing reactions between thermal degradation causing factors, such as moisture, oxygen, light and heat, enables fabrication of a light emitting device package having an extended lifespan and enhanced reliability.

Therefore, in the embodiments, the protective layer 500 containing the moisture blocking material and/or the ultraviolet blocking material serves to block the thermal degradation causing factors, such as moisture, oxygen, light and heat.

In the embodiments, the protective layer 500 may be formed at various positions.

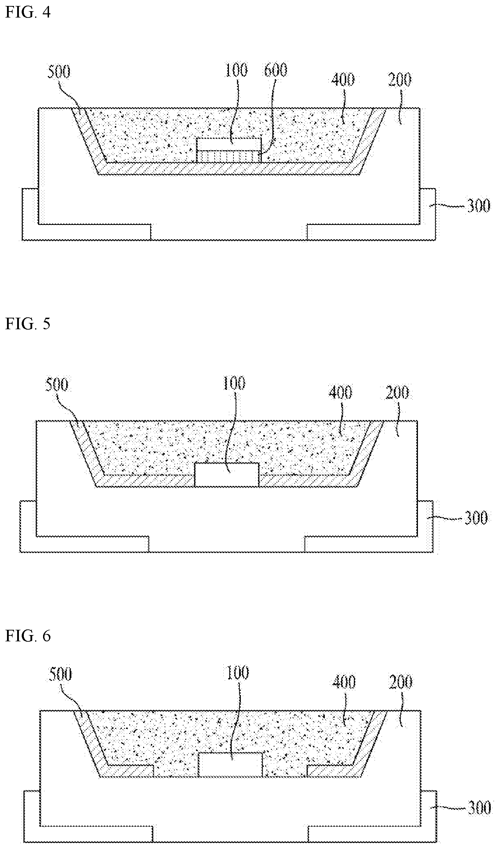

FIGs. 4 to 9 are views illustrating various positions of the protective layer according to different embodiments not part of the invention.

As illustrated in FIG. 4, the protective layer 500 may be formed throughout the entire inner surface of the injection space for the filler 400.

Specifically, the protective layer 500 may be formed between the filler 400 and the package body 200 and between the light emitting device 100 and the package body 200.

An adhesive layer 600 may further be formed between the light emitting device 100 and the protective layer 500, to enhance adhesion between the light emitting device 100 and the protective layer 500.

The adhesive layer 600 may be conductive or nonconductive according to characteristics of the light emitting device 100, and may contain at least one of epoxy resin and silicon resin.

As occasion demands, the adhesive layer 600 may be omitted according to the material of the protective layer 500.

For example, if the material of the protective layer 500 exhibits efficient adhesion to the light emitting device 100, the adhesive layer 600 may be omitted. The adhesive layer 600 may be provided only under the assumption that the material of the protective layer 500 exhibits insufficient adhesion to the light emitting device 100.

Alternatively, as illustrated in FIG. 5, the protective layer 500 may be formed between the filler 400 and the package body 200, but may be omitted between the light emitting device 100 and the package body 200.

Alternatively, as illustrated in FIG. 6, the protective layer 500 may be formed only at a region spaced apart from the light emitting device 100 by a predetermined distance.

Specifically, the protective layer 500 is formed only on the surface of the package body 200 at which the light generated from the light emitting device 100 arrives. Thus, the protective layer 500 needs not be formed at a region adjacent to the light emitting device 100 at which little light arrives.

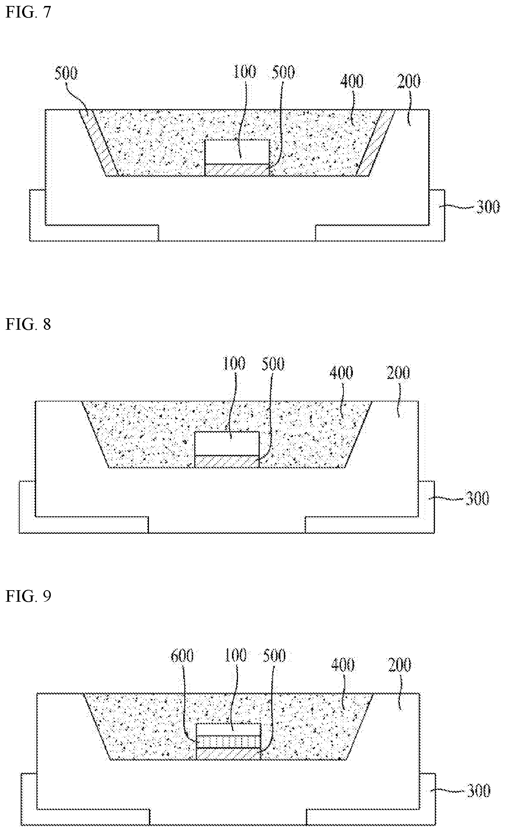

Alternatively, as illustrated in FIG. 7, the protective layer 500 may be formed only at a lateral surface of the recess, i.e. the filler injection space of the package body 200 and below the light emitting device 100.

This is because light generated by the light emitting device 100 has the greatest effect on the lateral surface of the recess of the package body 200 and heat generated by the light emitting device 100 has the greatest effect on a region below the light emitting device 100.

Thus, the protective layer 500 may be formed only at regions on which the light and heat generated by the light emitting device 100 have the greatest effect.

Alternatively, as illustrated in FIG. 8, the protective layer 500 may be formed only on the surface of the package body 200 coming into contact with the light emitting device 100.

That is, the protective layer 500 is formed only below the light emitting device 100 because the protective layer 500 may reduce the brightness of light emitted from the entire light emitting device package.

Thus, the protective layer 500 is formed only below the light emitting device 100 that is vulnerable to moisture, in order to enhance the brightness of light emitted from the entire light emitting device package.

Alternatively, as illustrated in FIG. 9, the adhesive layer 600 may further be formed between the light emitting device 100 and the protective layer 500.

The adhesive layer 600 serves to enhance adhesion between the light emitting device 100 and the protective layer 500 and may contain at least one of epoxy resin and silicon resin.

Although the protective layer 500 may be a single layer made of at least one of the moisture blocking material, the ultraviolet blocking material, and mixtures thereof, the protective layer 500 may be a stack of several layers.

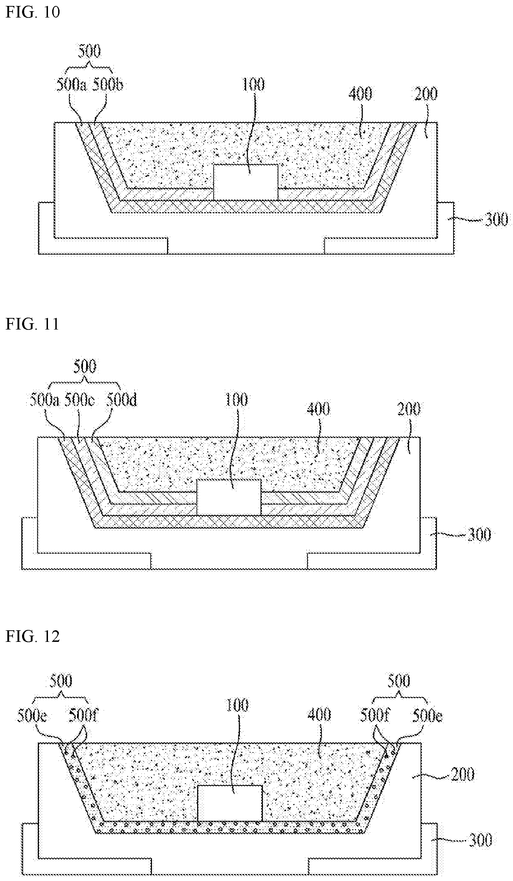

FIGs. 10 and 11 are views illustrating a multilayered protective layer. More particularly, FIG. 10 illustrates a dual-layer protective layer, and FIG. 11 illustrates a triple-layer protective layer.

Referring to FIG. 10, the protective layer 500 may be comprised of a plurality of layers including a first layer 500a to block moisture and a second layer 500b to block ultraviolet light.

The first layer 500a may contain at least one of polytetrafluoroethylene (PTFE), fire-retardant polyvinylchloride (PVC), fire-retardant polyester, polyethyleneimide (PEI), silicon, silicon rubber, fluoro resin, Teflon, polyvinylchloride (PVC), polyethylene (PE), poly olefin (PO), CF₄, CH₄, or tetraethyl othrosilicate (TEOS).

The second layer 500b may contain at least one of chrome, aluminum, titanium dioxide, zinc oxide, magnesium silicate, magnesium oxide, or kaolin.

The reason why the protective layer 500 has a dual-layer configuration is that the second layer 500b to block ultraviolet light from the light emitting device 100 may restrict reactions with moisture or oxygen and the first layer 500a to block moisture permeated from the outside may restrict reactions induced by light emitted from the light emitting device 100.

Referring to FIG. 11, the protective layer 500 may be comprised of a plurality of layers including the first layer 500a to block moisture, a second layer 500c to reflect light emitted from the light emitting device 100, and a third layer 500d to enhance adhesion to the filler 400.

The first layer 500a to block moisture may contain at least one of polytetrafluoroethylene (PTFE), fire-retardant polyvinylchloride (PVC), fire-retardant polyester, polyethyleneimide (PEI), silicon, silicon rubber, fluoro resin, Teflon, polyvinylchloride (PVC), polyethylene (PE), poly olefin (PO), CF₄, CH₄, or tetraethyl othrosilicate (TEOS).

The second layer 500c to reflect light may contain at least one of Al, Ag, Au, or TiO₂, and the third layer 500d to enhance adhesion may contain at least one of epoxy resin and silicon resin.

In some embodiments not part of the invention, the package body may include a lead frame serving only to reflect light, or the lead frame may be provided with the second layer 500c. Also, the triple-layer protective layer 500 formed on the package body is not limited in terms of stacking sequence.

In the triple-layer protective layer 500 as illustrated in FIG. 11, the first layer 500a acts to block moisture permeated from the outside, thereby restricting reactions by light emitted from the light emitting device 100, the second layer 500c acts to reflect the light emitted from the light emitting device 100, thereby improving the brightness of light as well as restricting reactions with moisture or oxygen, and the third layer 500d acts to enhance adhesion to the filler, thereby restricting permeation of moisture.

Alternatively, the protective layer 500 may be a single layer made of a mixture of the moisture blocking material and the ultraviolet blocking material.

FIG. 12 is a view illustrating a protective layer made of a mixture.

As illustrated in FIG. 12, the protective layer 500 may be made of a mixture of moisture blocking material 500e and ultraviolet blocking material 500f.

The ultraviolet blocking material 500f may take the form of nano-scale particles. The particle size of the ultraviolet blocking material 500f may be in a range of about 10 nm to 500 nm.

The particles may have the same size, or may have different sizes as occasion demands.

In addition, a high density of particles of the ultraviolet blocking material 500f may be present in a region adjacent to the filler 400, and a low density of particles of the ultraviolet blocking material 500f may be present in a region adjacent to the package body 200.

As occasion demands, the particle density may gradually increase from the region adjacent to the package body 200 to the region adjacent to the filler 400.

This is because the intensity of light arriving at the protective layer 500 is greater at the region adjacent to the filler 400 than at the region adjacent to the package body 200.

In the invention the protective layer 500 has at least one of a toothed pattern and a recessed pattern on the entire surface or a partial surface thereof.

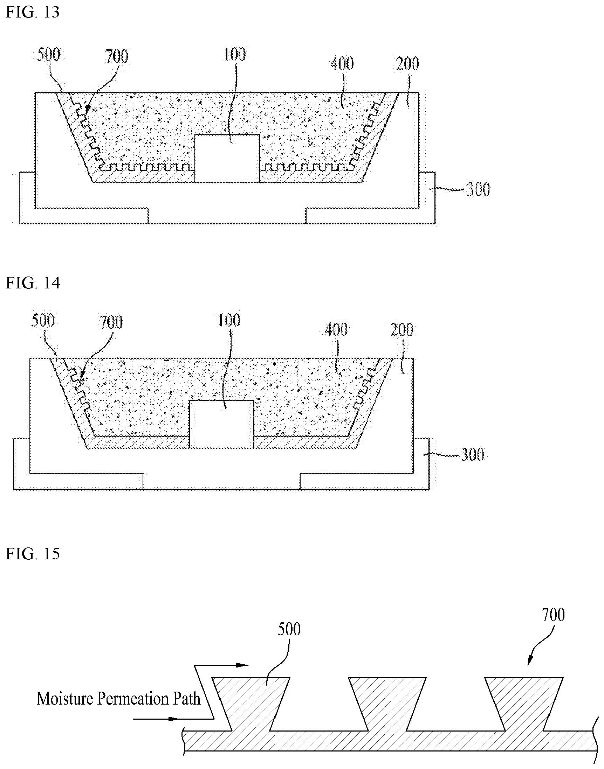

FIGs. 13 and 14 are views illustrating a protective layer having teeth. More particularly, FIG. 13 illustrates a protective layer having teeth formed on the entire surface thereof, and FIG. 14 illustrates a protective layer having teeth formed on a partial surface thereof. The teeth may define a pattern according to the embodiments.

As illustrated in FIG. 13, the protective layer 500 may be provided at the entire surface thereof with a toothed pattern 700 of a stripe type or a dot type.

Alternatively, as illustrated in FIG. 14, the protective layer 500 may be provided at only a partial surface thereof adjacent to the outside with the toothed pattern 700.

FIG. 15 is a sectional view of the toothed pattern. As illustrated in FIG. 15, the toothed pattern of FIGs. 13 and 14 has an inverted trapezoidal shape such that the width of an upper surface thereof is greater than the width of a lower surface thereof.

This is because permeation of moisture follows a path from a side surface to an upper surface of the toothed pattern and a side surface of the inverted trapezoidal toothed pattern impedes permeation of moisture.

The protective layer 500 having the toothed pattern has a great contact area with the filler 400, thus exhibiting enhanced adhesion and moisture blocking effects.

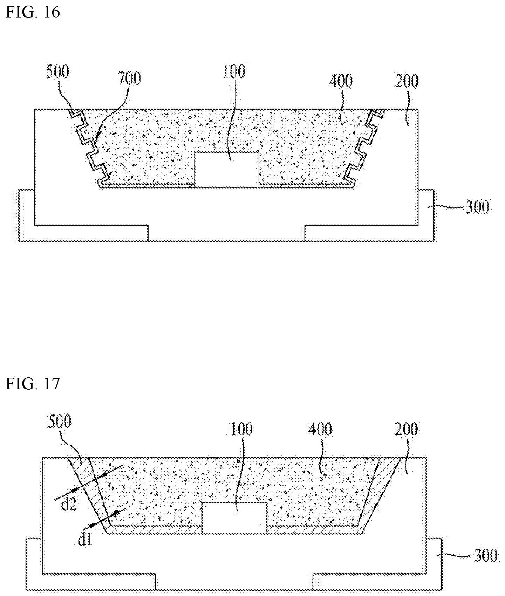

FIG. 16 is a view illustrating a protective layer formed on a package body having a toothed pattern. As illustrated in FIG. 16, the package body 200 may be provided at the surface thereof with the toothed pattern 700 of a stripe type or a dot type, and the protective layer 500 formed on the package body 200 having the toothed pattern 700 may be provided at the surface thereof with the same toothed pattern.

The protective layer 500 having the above-described configuration has a greater contact area with the package body 200 and a greater contact area with the filler 400, thereby exhibiting enhanced adhesion and moisture blocking effects.

In an alternative configuration not part of the invention, the thickness of the protective layer 500 may be gradually increased toward the outer surface of the package body 200.

FIG. 17 is a view illustrating a protective layer having a gradually varying thickness. As illustrated in FIG. 17, a thickness d1 of the protective layer 500 located at the inner region of the package body 200 may be smaller than a thickness d2 of the protective layer 500 located at the outer region of the package body 200.

This is because the quantity of moisture permeated into the outer region of the package body 200 is greater than the quantity of moisture permeated into the inner region of the package body 200.

The protective layer 500, the thickness of which is varied on a per region basis, is applicable to all the embodiments disclosed herein.

In an alternative configuration not part of the invention, the protective layer may be formed in fine recesses of the package body.

FIGs, 18 and 19 are respectively a perspective view and a sectional view illustrating a package body having a pattern of a plurality of fine recesses and a protective layer.

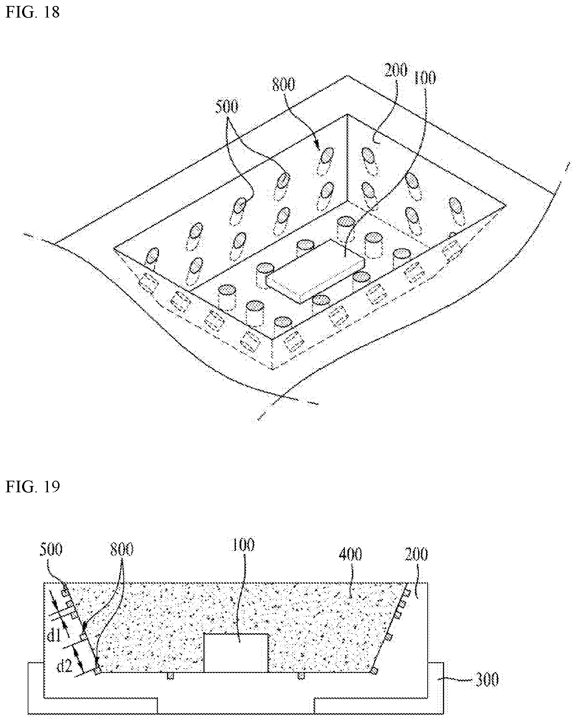

As illustrated in FIGs. 18 and 19, a plurality of fine recesses 800 is formed on the surface of the package body 200 within the filler injection space, and each fine recess 800 may be filled with the protective layer 500.

As illustrated in FIG. 19, the fine recesses 800 of the package body 200 may have the same size and depth, As occasion demands, the fine recesses 800 having various sizes and depths may be provided together on the surface of the package body 200

A high density of the fine recesses 800 may be formed at the outer region of the package body 200, and a low density of the fine recesses 800 may be formed at the inner region of the package body 200.

As occasion demands, the density of the fine recesses 800 may gradually increase from the inner region to the outer region of the package body 200.

Thus, a distance d1 between the fine recesses 800 located at the outer region of the package body 200 may be smaller than a distance d2 between the fine recesses 800 located at the inner region of the package body 200,

This is because the quantity of light permeating into the outer region of the package body 200 is greater than the quantity of light permeating into the inner region of the package body 200. As proposed in the above-described various embodiments, providing the protective layer, which contains the moisture blocking material and/or the ultraviolet blocking material, inside the recess of the package at which light or heat generated by the light emitting device arrives may prevent reactions between exterior moisture and oxygen and light and heat emitted from the light emitting device, thereby preventing thermal degradation of the package.

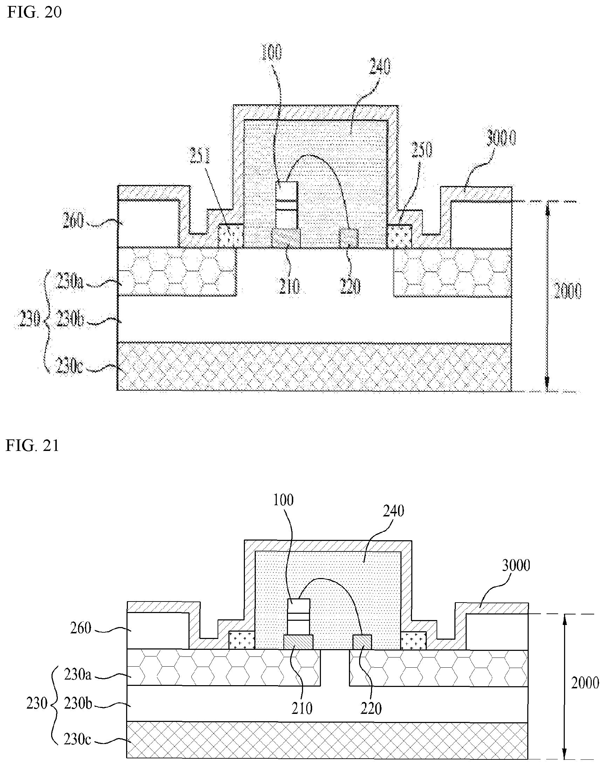

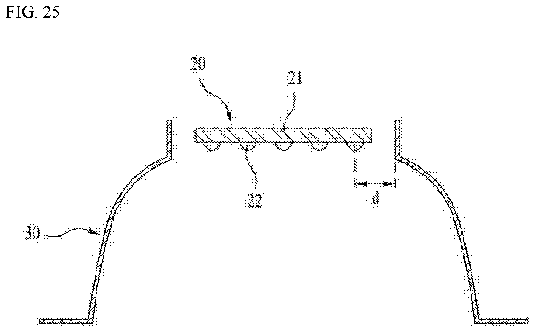

FIG. 20 is a view illustrating a basic concept of a light emitting device array module according to an embodiment. The embodiments related to fig. 20∼fig. 25 do not form part of the invention.

As illustrated in FIG. 20, the light emitting device array module may include the light emitting device 100, a supporting substrate 2000, and a protective layer 3000. The supporting substrate 2000 is one example of the above-described package body in some embodiments.

Here, at least one light emitting device 100 may be provided on the supporting substrate 2000.

As previously described above, the light emitting device 100 may be classified into horizontal, vertical and hybrid types and may be selected from among various shapes of light emitting devices.

The supporting substrate 2000 may be a substrate on which a plurality of light emitting devices 100 is mounted, and may be provided with an electrode pattern to connect a power supply adaptor and the light emitting devices 100 to each other.

For example, a carbon nanotube electrode pattern may be formed at an upper surface of the supporting substrate 2000 to connect the light emitting devices 100 and the adaptor to each other.

The supporting substrate 2000 may be made of polyethyleneterephthalate (PET), glass, polycarbonate (PC), or silicon (Si) and may take the form of a film. The supporting substrate 200 may be a printed circuit board (PCB) on which a plurality of light emitting devices 100 is mounted.

FIG. 20 illustrates an embodiment of a Chip On Board (COB) type light emitting device array module. The supporting substrate 2000 may include a supporting layer 230 in which a first electrode region 210 and a second electrode region 220 are defined, lead frames 250 and 251, and a solder resist layer 260. The light emitting device 100 formed on the supporting substrate 2000 may be covered with a filler 240.

The first electrode region 210 may be connected to a first electrode of the light emitting device 100 and the second electrode region 220 may be connected to a second electrode of the light emitting device 100.

The supporting layer 230 may include an insulating layer 230b supporting the first and second electrode regions 210 and 220, a circuit layer 230a formed on the insulating layer 230b, and a heat spreading layer 230c formed below the insulating layer 230b.

The filler 240 may serve as a light transmittance filler to seal the first and second electrode regions 210 and 220 including the light emitting device 100, and may be made of silicon or acryl based resin.

Of course, the filler 240 is not limited to the aforementioned materials and may be made of various resins. To assure uniform brightness, the filler 240 may be made of a resin having a refractive index of about 1.4 to 1.6

For example, the filler 240 may be made of any one material selected from the group of polyethyleneterephthalate (PET), polycarbondate (PC), polypropylene (PP), polyethylene (PE), polystylene (PS), polyepoxy (PE), silicon, and acryl.

The filler 240 may contain an adhesive polymer resin so as to be firmly attached to the light emitting device 100.

For example, the filler 240 may contain acryl based, urethane based, epoxy based, and melamine based materials, such as unsaturated polyester, methylmethacrylate, ethylmethacrylate, isobutylmethacrylate, n-butylmethacrylate, n-butylmethymethacrylate, acrylic acid, methacrylic acid, hydroxyethylmethacrylate, hydroxypropylmethacrylate, hydroxyethylacrylate, acrylamide, methylolacrylamide, glycidilmethacrylate, ethylacrylate, isobutylacrylate, n-butylacrylate, 2-ethylhexylacrylate polymers, copolymers, or terpolymers.

The filler 240 may be formed by applying a liquid-phase or gel-phase resin to the supporting layer 230 on which the plurality of light emitting devices 100 is formed and hardening the applied resin, or may be formed by applying a resin to another supporting sheet and partially hardening the applied resin to attach the supporting sheet to the supporting layer 230.

The lead frames 250 and 251 may be electrically connected to the first and second electrode regions 210 and 220, and may be formed on the supporting layer 230 around the light transmission filler 240.

In one embodiment, as illustrated in FIG. 21, the lead frame 251 may be electrically connected to the first electrode region 210 via the circuit layer 230a, the lead frame 250 may be electrically connected to the second electrode region 220 via the circuit layer 230a, and the second electrode region 220 may be electrically connected to the light emitting device 100 via a wire.

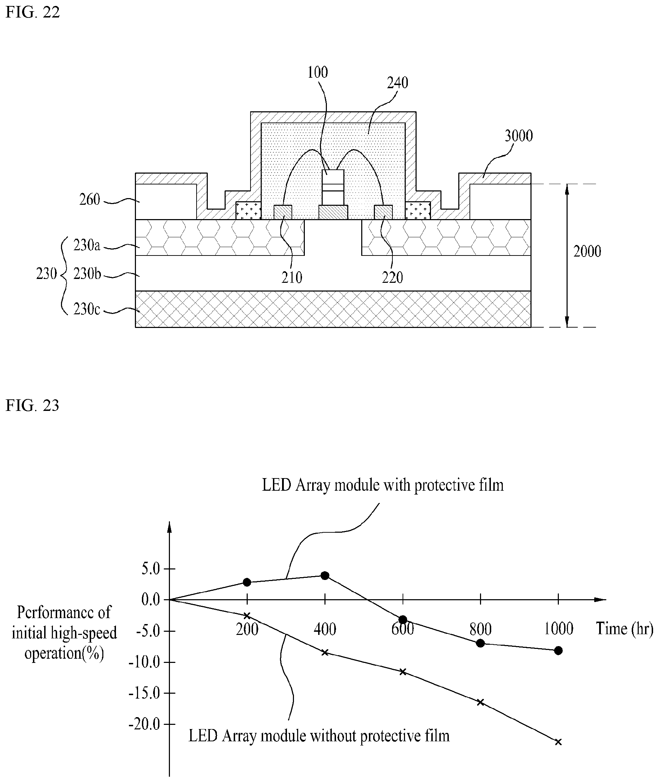

In another embodiment, as illustrated in FIG. 22, the lead frame 251 may be electrically connected to the first electrode region 210 via the circuit layer 230a, the lead frame 250 may be electrically connected to the second electrode region 220 via the circuit layer 230a, and the second electrode region 220 may be electrically connected to the light emitting device 100 using a wire.

The solder resist layer 260 is formed around the lead frame 250 and may serve to prevent a short circuit between electrodes.

Next, the protective layer 3000 may be formed on the supporting substrate 2000 on which the at least one light emitting device 100 is arranged.

As occasion demands, the protective layer 3000 may be formed on at least one of the entire surface of the light transmission filler 240, the entire surface of the lead frames 250 and 251, the entire surface of the solder resist layer 260, and the entire surface of the supporting layer 230.

In a most preferred embodiment, the protective layer 3000 is formed to a constant thickness throughout the entire surface of the supporting substrate 2000 on which the light emitting device 100 is arranged.

The protective layer 3000 may be made of a moisture-proof material having a moisture transmission rate of about 1000 g/m₂ every 24 hours.

For example, the protective layer 3000 may contain at least one of polytetrafluoroethylene (PTFE), fire-retardant polyvinylchloride (PVC), fire-retardant polyester, polyethyleneimide (PEI), silicon, silicon rubber, fluoro resin, Teflon, polyvinylchloride (PVC), polyethylene (PE), poly olefin (PO), CF₄, CH₄, or tetraethyl othrosilicate (TEOS).

For example, the protective layer 3000 may contain a moisture-proof material having a moisture transmission rate of about 5 to 800 g/m₂ every 24 hours.

In this case, a thickness of the protective layer 3000 may be in a range of about 1 µm to 200 µm.

The moisture transmission rate of the protective layer 3000 may be changed according to the kind and composition ratio of the moisture-proof material contained in the protective layer 3000 and the thickness of the protective layer 3000 and thus, may be determined by appropriately controlling the aforementioned factors.

For example, the following Table represents the moisture transmission rate of the protective layer 3000 depending on the thickness of the protective layer 3000 under the assumption that the moisture-proof material of the protective layer 3000 is fluoro resin.

**Table 1**

| Moisture-proof material | Thickness (µm) | Moisture transmission rate (g/m₂/24H) |
|---|---|---|
| fluoro resin | 8 | 640 |
| fluoro resin | 34 | 210 |
| | 120 | 38 |

As illustrated in the above Table 1, it is necessary to determine the thickness of the protective layer such that the protective layer has an appropriate moisture transmission rate according to the type of the light emitting device array module.

This is because the brightness of the light emitting device may be reduced if the protective layer becomes excessively thick.

In addition, the protective layer must be formed in consideration of the above requirements because it is impossible to increase the thickness of the protective layer indefinitely due to a design limit in the thickness of the module to which the present embodiment is applied.

The present embodiment is applicable to various array modules, such as a general LED package array module, a Chip On Board (COB) type LED array module, and a dome-shaped COB LED array module.

FIG. 23 is a graph comparing performances of initial high-speed operations per unit time based on the presence and absence of a protective layer.

As illustrated in FIG. 23, it will be appreciated that a light emitting device array module having a protective layer maintains substantially the same performance of an initial high-speed operation without a great change as time passes.

The graph shows that a light emitting device array module having a protective layer shows a slight deterioration in performance after about 600 hours.

On the contrary, it will be appreciated that a light emitting device array module without a protective layer exhibits a sharp drop in performance after about 200 hours.

That is, the graph of FIG. 23 shows that the light emitting device array module without a protective layer has a sharp drop in performance due to corrosive agents and moisture from the outside, thus exhibiting deterioration in reliability and lifespan thereof, whereas the light emitting device array module having the protective layer is free from thermal degradation by blocking permeation of corrosive agents and moisture, thus achieving enhanced reliability and extended lifespan.

A method for forming the protective layer of the light emitting device array module having the above-described configuration is as follows.

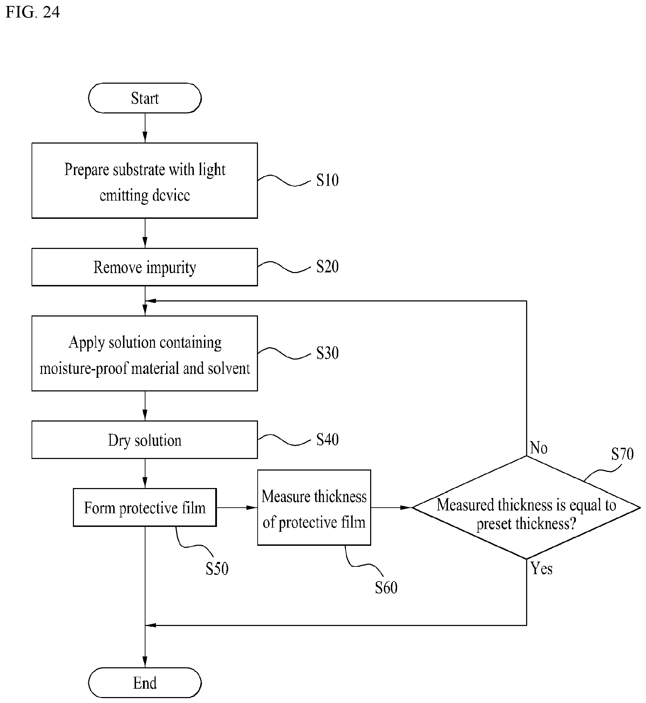

FIG. 24 is a flow chart illustrating a method for forming a protective layer of a light emitting device array module according to an embodiment.

As illustrated in FIG. 24, first, a substrate on which at least one light emitting device is arranged is prepared (S10).

Next, impurities, such as dust, oil, water droplets, etc., present on a surface of the substrate are removed (S20).

This is because the impurities present on the surface of the substrate may deteriorate adhesion between the substrate and a protective layer.

Next, at least one coat of a solution containing a moisture-proof material and solvent is applied to the surface of the substrate from which the impurities have been removed (S30).

The moisture-proof material may include at least one of polytetrafluoroethylene (PTFE), fire-retardant polyvinylchloride (PVC), fire-retardant polyester, polyethyleneimide (PEI), silicon, silicon rubber, fluoro resin, Teflon, polyvinylchloride (PVC), polyethylene (PE), poly olefin (PO), CF₄, CH₄, or tetraethyl othrosilicate (TEOS).

The solvent may be at least one of hydrofluorocarbon (HFC), hydrofluoroether (HFE), or perfluoropolyether (PFPE).

In this case, the density of the moisture-proof material contained in the solution may be in a range of about 1% to 70%.

If the density of the moisture-proof material is about 1% or less, the protective layer may have a high moisture transmission rate, i.e. deterioration in moisture-proofing. On the contrary, if the density of the moisture-proof material is about 70% or more, application of the protective layer may be difficult, making formation of the protective layer difficult.

The solution may be applied using at least one of spraying, brushing, and dipping.

Spraying is a method of spraying a solution over a surface of a substrate using an injector, brushing is a method of spreading a solution over a surface of a substrate using a brush, and dipping is a method of dipping a substrate into a solution.

The solution applied by the above-described method is subjected to drying (S40).

Here, the drying of the solution may be performed at a room temperature for about 2 seconds to 1 hour.

The drying time may be changed according to the density of the moisture-proof material contained in the solution.

For example, the following Table represents drying time depending on the density of the moisture-proof material under the assumption that the moisture-proof material of the solution is fluoro resin.

**Table 2**

| Density of Moisture-proof material | Drying time |
|---|---|
| 1-2% | 5-20 sec. |
| 4-10% | 30-60 sec. |
| 10-20% | 1-5 min. |
| 20-70% | 10-25 min |

With implementation of the drying operation, a protective layer having a moisture transmission rate of about 1000 g/m₂ or less every 24 hours may be formed (S50).

The protective layer may have a thickness of about 1 µm to 200 µm, and the thickness of the protective layer must be determined to provide the protective layer with an appropriate moisture transmission rate according to the type of the light emitting device array module.

As described above, this is because the brightness of the light emitting device may be reduced when the protective layer becomes excessively thick.

Accordingly, in the present embodiment, an operation of measuring the thickness of the protective layer may follow the protective layer formation.

As illustrated in FIG. 24, after the protective layer formation (S50), the thickness of the protective layer may be measured (S60).

Next, it is determined whether or not the measured thickness is equal to a preset thickness (S70).

If the measured thickness is not equal to the preset thickness, the solution application (S30) is repeated. Once the thickness of the protective layer reaches the preset thickness, the protective layer formation may be ended.

The thickness measurement of the protective layer is included so that the protective layer formation can be more accurately and rapidly performed based on reference values of the thickness and moisture transmission rate of the protective layer which are previously determined in consideration of the moisture-proof material of the protective layer and the brightness of the light emitting device.

In this way, the above-described various embodiments may prevent thermal degradation of the light emitting device array module and corrosion of electrodes, providing the light emitting device array module with enhanced reliability and extended lifespan.

Further, coating the protective layer in a simplified manner within a short drying time may reduce the formation time and costs, and providing the protective layer with enhanced moisture-proofing performance may reduce the thickness of the protective layer, enabling a reduction in the weight of the light emitting device array module.

When the embodiments are applied to a lighting module subjected to harsher environmental conditions than a backlight module, it is possible to prevent deterioration in reliability caused when the module is exposed to exterior moisture or oxygen, thus providing the module with an extended lifespan.

The light emitting device package according to the present embodiment may include an array of a plurality of light emitting devices. Also, the light emitting device package or the light emitting device array module may include optical members, such as a light guide plate, a prism sheet, and a diffusion sheet, and thus, may function as a light unit.

In other embodiments, a display device, an indicating device, and a lighting system including the light emitting device package of the light emitting device array module disclosed in the above-described embodiments may be realized. For example, the lighting system may be a lamp or a street lamp.

The lighting system may serve as a light including a plurality of LEDs, and in particular, may take the form of a built-in light (e.g., an LED down light) that is embedded in the ceiling or wall of a building such that an opening of a shade is exposed to the outside.

FIG. 25 is a view illustrating an embodiment of a lighting apparatus having a light emitting device package or a light emitting device array module. As illustrated in FIG. 25, the lighting apparatus includes an LED package or LED array module 20, and a shade 30 to allow light emitted from the LED package or LED array module 20 to be oriented to a desired angle.

The LED package or LED array module 20 may include at least one LED 22 provided on the printed circuit board 21. Of course, a plurality of LEDs 22 may be arranged on the printed circuit board 21.

The shade 30 condenses the light emitted from the LED package 22 to allow the light to be emitted through an opening thereof at a predetermined orientation angle, and may include an inner mirror surface.

Here, the LED package or LED array module 20 may be spaced apart from the shade 30 by a predetermined distance d.

The lighting apparatus, as described above, may serve to emit light by condensing the light from the plurality of LEDs 22. In particular, the lighting apparatus may take the form of a built-in light (e.g., an LED down light) that is embedded in the ceiling or wall of a building such that the opening of the shade is exposed to the outside.

The lighting apparatus using the light emitting device package may include a supporting substrate on which at least two light emitting device packages are located, and a case, at least a portion of which is made of a light transmission material through which light emitted from the light emitting device packages passes.

As is apparent from the above description, according to the embodiments of the present invention, as a result of forming a protective layer containing a moisture or ultraviolet light blocking material inside a recess of a package at which light or heat generated by a light emitting chip arrives, the protective layer has the effect of preventing reactions between moisture and oxygen permeated from the outside and light and heat generated by the light emitting device, thereby preventing thermal degradation of a light emitting device package.

Further, the protective layer may also be coated on an outer surface of a substrate on which the light emitting device is arranged so as to block corrosive agents and moisture. This may prevent thermal degradation of a light emitting device array module and corrosion of electrodes, resulting in enhanced reliability and extended lifespan.

Furthermore, coating the protective layer in a simplified manner within a short drying time may reduce the formation time and costs.

Also, providing the protective layer with enhanced moisture-proofing performance may reduce the thickness of the protective layer, enabling a reduction in the weight of the light emitting device array module.

When the embodiments are applied to a lighting module subjected to harsher environmental conditions than a backlight module, it is possible to prevent deterioration in reliability caused when the module is exposed to exterior moisture or oxygen, thus providing the module with an extended lifespan.

Although the present invention has been described about some specific embodiments, these embodiments are given by way of example and the scope of the present invention is limited by the appended claims.

## Claims

1. A light emitting device package comprising:
a light emitting device (100);
a package body (200) supporting the light emitting device (100);
at least one electrode (300) provided on the package body (200) and electrically connected to the light emitting device (100);
a encapsulant (400) covering the light emitting device (100); and
a protective layer (500) placed between the encapsulant (400) and the package body (200), wherein the protective layer (500) contains at least one selected from the group consisting of moisture blocking material and ultraviolet blocking material,
wherein at least a partial surface of the protective layer (500) contacting the encapsulant (400) includes a toothed pattern (700),
**characterized in that** the toothed pattern (700) has an inverted trapezoidal shape.

2. The light emitting device package according to claim 1, wherein the moisture blocking material includes at least one selected from the group consisting of polytetrafluoroethylene (PTFE), fire-retardant polyvinylchloride (PVC), fire-retardant polyester, polyethyleneimide (PEI), silicon, silicon rubber, fluoro resin, Teflon, polyvinylchloride (PVC), polyethylene (PE), poly olefin (PO), CF₄, CH₄, or tetraethyl othrosilicate (TEOS).

3. The light emitting device package according to any one of claims 1 to 2, wherein the ultraviolet blocking material includes at least one selected from the group consisting of chrome, aluminum, titanium dioxide, zinc oxide, magnesium silicate, magnesium oxide, or kaolin.

4. The light emitting device package according to any one of claims 1 to 3, wherein the protective layer (500) is made of a mixture of the moisture blocking material and the ultraviolet blocking material, and a particle size of the ultraviolet blocking material is in a range of 10 nm to 500 nm.

5. The light emitting device package according to any one of claims 1 to 4, wherein the protective layer (500) is formed on a surface of the package body (200) around the light emitting device.

## Patentansprüche

1. Lichtemittierungsvorrichtungsbaugruppe umfassend:
eine Lichtemittierungsvorrichtung (100);
einen Baugruppenkörper (200), der die Lichtemittierungsvorrichtung (100) trägt;
wenigstens eine Elektrode (300), die an dem Baugruppenkörper (200) vorgesehen und mit der Lichtemittierungsvorrichtung (100) elektrisch verbunden ist;
ein Kapselungsmittel (400), das die Lichtemittierungsvorrichtung (100) bedeckt; und
eine Schutzschicht (500), die zwischen dem Kapselungsmittel (400) und dem Baugruppenkörper (200) platziert ist, wobei die Schutzschicht (500) wenigstens eines enthält, das aus der Gruppe ausgewählt ist, die aus einem Feuchtigkeitsblockierungsmaterial und einem Ultraviolettblockierungsmaterial besteht,
wobei wenigstens eine Teiloberfläche der Schutzschicht (500), die das Kapselungsmittel (400) kontaktiert, ein gezahntes Muster (700) umfasst,
**dadurch gekennzeichnet, dass** das gezahnte Muster (700) eine umgekehrte Trapezform aufweist.

2. Lichtemittierungsvorrichtungsbaugruppe nach Anspruch 1, wobei das Feuchtigkeitsblockierungsmaterial wenigstens eines umfasst, das aus der Gruppe ausgewählt ist, die aus Polytetrafluorethylen (PTFE), feuerhemmendem Polyvinylchlorid (PVC), feuerhemmendem Polyester, Polyethyleneimid (PEI), Silicium, Siliciumgummi, Fluorharz, Teflon, Polyvinylchlorid (PVC), Polyethylen (PE), Polyolefin (PO), CF₄, CH₄, oder Tetraethylothrosilicat (TEOS) besteht.

3. Lichtemittierungsvorrichtungsbaugruppe nach einem der Ansprüche 1 bis 2, wobei das Ultraviolettblockierungsmaterial wenigstens eines umfasst, das aus der Gruppe ausgewählt ist, die aus Chrom, Aluminium, Titandioxid, Zinkoxid, Magnesiumsilicat, Magnesiumoxid oder Kaolin besteht.

4. Lichtemittierungsvorrichtungsbaugruppe nach einem der Ansprüche 1 bis 3, wobei die Schutzschicht (500) aus einem Gemisch des Feuchtigkeitsblockierungsmaterials und des Ultraviolettblockierungsmaterials besteht, und eine Partikelgröße des Ultraviolettblockierungsmaterials in einem Bereich von 10 nm bis 500 nm liegt.

5. Lichtemittierungsvorrichtungsbaugruppe nach einem der Ansprüche 1 bis 4, wobei die Schutzschicht (500) an einer Oberfläche des Baugruppenkörpers (200) um die Lichtemittierungsvorrichtung herum gebildet ist.

## Revendications

1. Un boîtier de dispositif émetteur de lumière comprenant :
un dispositif (100) émetteur de lumière ;
un corps de boîtier (200) supportant le dispositif (100) émetteur de lumière ;
au moins une électrode (300) prévue sur le corps de boîtier (200) et reliée électriquement au dispositif (100) émetteur de lumière ;
un élément d'encapsulation (400) recouvrant le dispositif (100) émetteur de lumière ; et
une couche protectrice (500) placée entre l'élément d'encapsulation (400) et le corps de boîtier (200), la couche protectrice (500) contenant au moins un, sélectionné, choisi dans le groupe constitué par : un matériau bloquant l'humidité et un matériau bloquant les ultraviolets,
au moins une surface partielle de la couche de protection (500) en contact avec l'élément d'encapsulation (400) comprenant une conformation dentée (700),
**caractérisé en ce que** la conformation dentée (700) a une forme trapézoïdale inversée.

2. Le boîtier de dispositif émetteur de lumière selon la revendication 1, dans lequel le matériau bloquant l'humidité comprend au moins un matériau choisi dans le groupe consistant en : du polytétrafluoroéthylène (PTFE), du polychlorure de vinyle (PVC) ignifuge, du polyester ignifuge, du polyéthylèneimide (PEI), du silicium, du caoutchouc de silicone, de la résine fluorée, du téflon, du polychlorure de vinyle (PVC), du polyéthylène (PE), une polyoléfine (PO), du CF₄, CH₄ ou de l'orthrosilicate tétraéthyl (TEOS).

3. Le boîtier du dispositif émetteur de lumière selon l'une quelconque des revendications 1 à 2, dans lequel le matériau bloquant les ultraviolets comprend au moins un élément choisi dans le groupe consistant en : le chrome, l'aluminium, le dioxyde de titane, l'oxyde de zinc, le silicate de magnésium, l'oxyde de magnésium ou le kaolin.

4. Le boîtier de dispositif émetteur de lumière selon l'une quelconque des revendications 1 à 3, dans lequel la couche protectrice (500) est constituée d'un mélange du matériau bloquant l'humidité et du matériau bloquant les ultraviolets, et une taille de particules du matériau bloquant les ultraviolets est comprise dans une gamme allant de 10 nm à 500 nm.

5. Le boîtier de dispositif émetteur de lumière selon l'une quelconque des revendications 1 à 4, dans lequel la couche protectrice (500) est formée sur une surface du corps de boîtier (200) située autour du dispositif émetteur de lumière.
